(19) Europäisches Patentamt

European Patent Office

Office européen des brevets

(11) **EP 0 689 058 B1**

(12) **EUROPÄISCHE PATENTSCHRIFT**

(45) Veröffentlichungstag und Bekanntmachung des Hinweises auf die Patenterteilung:
**20.08.2003   Patentblatt 2003/34**

(51) Int Cl.$^7$: **G01R 31/02**, G01R 31/316

(21) Anmeldenummer: **95201598.0**

(22) Anmeldetag: **15.06.1995**

(54) **Schaltungsanordnung zum Überwachen eines Schaltungspunktes auf einen Leckwiderstand**

Circuit for monitoring a switching point regarding a leaking resistance

Circuit pour surveiller le point de déclenchement vis à vis d'une résistance de fuite

(84) Benannte Vertragsstaaten:
**DE FR GB IT**

(30) Priorität: **24.06.1994   DE 4422264**

(43) Veröffentlichungstag der Anmeldung:
**27.12.1995   Patentblatt 1995/52**

(73) Patentinhaber: **SIEMENS AKTIENGESELLSCHAFT
80333 München (DE)**

(72) Erfinder:
• **Beier, Ralf
D-22455 Hamburg (DE)**
• **Näthe, Axel
D-22417 Hamburg (DE)**

• **Swart, Marten
D-93083 Obertraubling (DE)**
• **Belau, Horst
D-93309 Kelheim-Kopfelberg (DE)**

(74) Vertreter: **Wörz, Hans-Walter et al
Siemens AG
Abteilung CT IP SV
Postfach 22 16 34
80506 München (DE)**

(56) Entgegenhaltungen:
**EP-A- 0 486 114**

• **PATENT ABSTRACTS OF JAPAN vol. 5, no. 117 (P-89) [849] , 13.November 1981 & JP 56 107175 A (SHARP)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

## Beschreibung

Die Erfindung betrifft eine Schaltungsanordnung zum Überwachen eines Schaltungspunktes, der in einem vorgegebenen Betriebszustand im störungsfreien Fall im wesentlichen zwischen einem ersten und einem zweiten Pol einer Betriebsspannung frei schwebend ist, auf einen Störzustand in Form eines Leckwiderstandes gegen wenigstens den einen Pol der Betriebsspannung, mit einer eine Stromquelle aufweisenden Prüfanordnung, die mit dem Schaltungspunkt gekoppelt ist, um diesem wenigstens einen vorgegebenen Prüfstrom zuzuführen, und mit einer Auswerteanordnung, die wenigstens einen Komparator aufweist, von dem ein Eingang mit dem Schaltungspunkt gekoppelt ist, um ein erstes Ausgangssignal abzugeben, wenn ein Strom durch den Leckwiderstand fließt.

Eine derartige Schaltungsanordnung ist bekannt aus der EP 0 486 114 A2. Die Stromquelle in der Prüfanordnung ist dabei als Stromspiegel ausgebildet, der mit einem Pol einer Spannungsquelle mit hoher Spannung verbunden ist und der einen Strom, der durch die Reihenschaltung eines Prüfobjektes und zweier Widerstände fließt und durch die Werte dieser Widerstände und der Spannung der Spannungsquelle bestimmt ist, in einen Ausgangsstrom umsetzt, der durch eine Reihenschaltung von zwei weiteren Widerständen fließt. Wenn durch das Prüfobjekt ein Leckstrom gegen einen Pol der Spannungsquelle abfließt, fließen in beiden Widerstandszweigen unterschiedliche Ströme, die zwischen den Verbindungspunkten der in Reihe geschalteten Widerstände eine entsprechende Differenzspannung erzeugen, die mit einem oder mehreren Komparatoren ausgewertet wird. Bei dieser bekannten Anordnung wird dem Prüfobjekt also ein Strom zugeführt, der wesentlich größer ist als der durch den zu überwachenden Leckwiderstand fließende maximale Leckstrom, und dieser dem Prüfobjekt zugeführte Strom wird durch Widerstände bestimmt, die zwischen dem zu messenden Schaltungspunkt und einem Pol der Betriebsspannung liegen, während der Teil des Stromspiegels, der einen Strom abgibt, einen Zweig speist, der nicht mit dem Prüfobjekt verbunden ist.

Häufig liegt der zu prüfende Schaltungspunkt innerhalb einer umfangreichen Schaltung, insbesondere einer integrierten Schaltung, oder stellt einen Ausgang einer solchen Schaltung nach außerhalb dar. Außerdem soll die Überprüfung auf einen Leckwiderstand nicht nur einmalig, beispielsweise bei der Herstellung erfolgen, sondern es soll eine ständig wiederholte Prüfung im normalen Betrieb möglich sein. Dabei ist es dann nicht zulässig, dem zu prüfenden Schaltungspunkt einen Strom zuzuführen, der wesentlich größer als ein Strom durch einen zulässigen Leckwiderstand ist, sondern der Schaltungspunkt soll unter allen Umständen möglichst hochohmig sein.

Aufgabe der Erfindung ist es, eine Schaltungsanordnung der eingangs genannten Art anzugeben, die innerhalb einer Schaltung angeordnet ist, mit niedriger Spannung arbeitet und die schnell eine Information bezüglich eines zu hohen Leckstroms an einem hochohmigen Schaltungspunkt liefern kann.

Diese Aufgabe wird erfindungsgemäß dadurch gelöst, daß die Stromquelle eine erste Stromquelle enthält, um dem Schaltungspunkt einen ersten Prüfstrom mit einer ersten Richtung zum ersten Pol zuzuführen, dessen Wert einem vorgegebenen Toleranzwert des Leckwiderstands entspricht, wobei dieser erste Prüfstrom nur fließt, wenn die Spannung zwischen dem Schaltungspunkt und dem ersten Pol einen vorgegebenen ersten Grenzwert unterschreitet, und daß der Komparator mit dem Schaltungspunkt verbunden ist, um die Spannung an diesem Schaltungspunkt mit einer vorgegebenen ersten Referenzspannung, die kleiner ist als der erste Grenzwert, zu vergleichen und das erste Ausgangssignal abzugeben, wenn die Spannung zwischen dem Schaltungspunkt und dem einen Pol der Betriebsspannung die erste Referenzspannung unterschreitet.

Eine solche Stromquelle kann beispielsweise durch einen Transistor gebildet werden, der bei dem ersten Grenzwert in die Sättigung gelangt oder der mit einer Klemmschaltung verbunden ist, die bei dem ersten Grenzwert wirksam wird. Solange der Leckwiderstand genügend groß ist, befindet sich die Spannung am Schaltungspunkt praktisch auf dem ersten Grenzwert. Erst wenn der Leckwiderstand den Toleranzwert unterschreitet und damit der Strom durch den Leckwiderstand den ersten Prüfstrom überschreitet, ändert sich die Spannung, was von dem Komparator ausgewertet wird. Die erste Referenzspannung kann daher durchaus wesentlich kleiner sein als der erste Grenzwert.

Häufig ist nicht nur die Überwachung eines Leckwiderstands gegen einen Pol der Betriebsspannung wichtig, sondern der Schaltungspunkt soll auf einen Leckwiderstand gegen jeden der beiden Pole der Betriebsspannung überwacht werden. Eine derartige Schaltungsanordnung ist nach einer Ausgestaltung der Erfindung dadurch gekennzeichnet, daß die Stromquelle eine zweite Stromquelle enthält, um dem Schaltungspunkt einen zweiten Prüfstrom mit einer zur ersten Richtung entgegengesetzten zweiten Richtung zum zweiten Pol zuzuführen, dessen Wert ebenfalls dem vorgegebenen Toleranzwert entspricht, wobei der zweite Prüfstrom nur fließt, wenn die Spannung zwischen dem Schaltungspunkt und dem anderen Pol einen vorgegebenen zweiten Grenzwert unterschreitet, wobei die beiden Grenzwerte einen Spannungsbereich einschließen, in dem beide Prüfströme fließen, und daß der Komparator ein Fensterkomparator ist, um die Spannung am Schaltungspunkt mit einer ersten und einer zweiten Referenzspannung zu vergleichen, die außerhalb des Spannungsbereichs liegen, und um wenigstens ein Signal abzugeben, wenn die Spannung am Schaltungspunkt außerhalb des durch die Referenzspannungen begrenzten Spannungsbereichs liegt.

Es werden also nicht nur zwei Stromquellen mit entgegengesetzter Richtung der Prüfströme verwendet, sondern es muß auch dafür gesorgt werden, daß die Spannungsbereiche, in denen die Stromquellen die Prüfströme liefern, sich überschneiden. Da der Komparator dann eine Abweichung nach beiden Seiten des Überschneidungsbereichs überwachen muß, muß dieser Komparator als Fensterkomparator ausgeführt sein.

Die beiden Stromquellen können unabhängig voneinander aufgebaut sein. Da die Prüfströme aus diesen beiden Stromquellen jedoch weitgehend gleich sein sollen, ist es nach einer weiteren Ausgestaltung der Erfindung zweckmäßig, daß die beiden Stromquellen über wenigstens einen ersten Stromspiegel miteinander gekoppelt sind, der zur Erzeugung des zweiten Prüfstroms einen Steuerstrom von einem zweiten Stromspiegel empfängt, der aus einem Referenzstrom den Steuerstrom und den ersten Prüfstrom erzeugt. Durch Änderung des Referenzstromes wird erreicht, daß beide Prüfströme sich in gleicher Weise ändern und dem Betrag nach weitgehend gleich bleiben.

Eine günstige Möglichkeit, den Referenzstrom zu erzeugen, besteht nach einer weiteren Ausgestaltung der Erfindung darin, daß der Referenzstrom durch einen zwischen einem Anschluß der Prüfschaltung, der im wesentlichen auf einem vorgegebenen Bruchteil der Betriebsspannung liegt, und dem einen Pol angeschlossenen externen Widerstand einstellbar ist. Auf diese Weise kann der Wert des Prüfstroms außerhalb der integrierten Schaltung leicht vorgegeben werden. Wenn dabei nach einer weiter Ausgestaltung der Erfindung jede Referenzspannung durch einen zwischen den Polen der Betriebsspannung angeordneten Spannungsteiler bestimmt wird, gibt der Komparator das erste Ausgangssignal unabhängig von der Höhe der Betriebsspannung ab, wenn das Verhältnis des Leckwiderstandes zum Referenzwiderstand einen von diesem Spannungsteiler abhängigen Wert überschreitet.

Ein zweckmäßiger Aufbau des Fensterkomparators ist nach einer weiteren Ausgestaltung der Erfindung dadurch gekennzeichnet, daß der Fensterkomparator zwei einzelne Komparatoren enthält, von denen jeder die Spannung am Schaltungspunkt mit einer anderen der beiden Referenzspannungen vergleicht. Dabei erzeugen beide Komparatoren einzeln Ausgangssignale abhängig davon, welche Referenzspannung unterschritten bzw. überschritten wird, und beide Ausgangssignale können bedarfsweise einzeln ausgewertet oder logisch zusammengefaßt werden.

Ein Komparator, der zwei Spannungen miteinander vergleicht, hat zwei Eingänge und einen Ausgang und ist häufig als Differenzverstärker aufgebaut. Damit ein solcher Komparator ein eindeutiges und stabiles logisches Signal abgibt, ist es nach einer weiteren Ausgestaltung der Erfindung zweckmäßig, daß ein Eingang jedes Komparators mit einem vom Signal am Ausgang dieses Komparators abschaltbaren Stromgenerator und mit einem Widerstand gekoppelt ist, dessen anderes Ende mit dem Schaltungspunkt bzw. mit der entsprechenden Referenzspannung verbunden ist, wobei der vom Stromgenerator gelieferte Strom vom Referenzstrom abgeleitet ist. Durch Verwendung eines Stromgenerators, dessen Strom von dem Referenzstrom und damit vom externen Widerstand abhängt, wird eine Hysterese erreicht, durch die der Wert des Leckwiderstandes, bei dem jeder Komparator das erste Ausgangssignal abgibt, vom Wert des externen Widerstands und des für die Hysterese verwendeten Widerstands sowie vom Spannungsteilerverhältnis abhängt, jedoch unabhängig von der Betriebsspannung ist.

Der Spannungsbereich, der durch die beiden Grenzwerte der Spannungen, bei denen die beiden Stromquellen einen Strom liefern, eingeschlossen wird, kann weitgehend frei zwischen den Potentialen der beiden Pole der Betriebsspannung gewählt werden. Um jedoch Leckwiderstände in etwa gleicher Größe gegen beide Pole der Betriebsspannung überwachen zu können, ist es nach einer weiteren Ausgestaltung der Erfindung zweckmäßig, daß der Spannungsbereich im wesentlichen in der Mitte zwischen den Potentialen der Pole der Betriebsspannung liegt. Dies kann durch entsprechende Wahl der Spannungen, bei denen die Prüfströme der beiden Stromquellen geklemmt werden, erreicht werden.

Wenn die Überprüfung eines Schaltungspunktes auf einen Leckstrom ständig durchgeführt wird, wird auch ständig Energie verbraucht, wenn auch nur in einem geringen Maße, was jedoch nicht immer erwünscht ist. Andererseits sind derartige zu überwachende Schaltungspunkte nicht immer hochohmig, sondern in manchen Betriebszuständen auch niederohmig insbesondere mit einem Pol der Betriebsspannung verbunden. Eine weitere Ausgestaltung der Erfindung, die für derartige Fälle zweckmäßig ist, ist daher dadurch gekennzeichnet, daß Mittel zum Abschalten der Stromquellen vorgesehen sind. Derartige Mittel können beispielsweise die Ansteuerung der Stromquellen abschalten oder auch einen Referenzstrom, der zur Erzeugung der Prüfströme verwendet wird, auf Null steuern.

Ausführungsbeispiele der Erfindung werden nachstehend anhand der Zeichnung näher erläutert. Es zeigen:

Fig. 1 ein Schaltbild zur Erläuterung des Prinzips der Erfindung,
Fig. 2 eine Realisierung einer Stromquelle,
Fig. 3a und 3b zwei Diagramme zur Erläuterung der verschiedenen Spannungen in der Schaltung,
Fig. 4 ein Schaltbild für die Überwachung eines Schaltungspunkts auf Leckströme in beiden Richtungen.
Fig. 5 ein Schaltbild für die Erzeugung einer Hysterese.

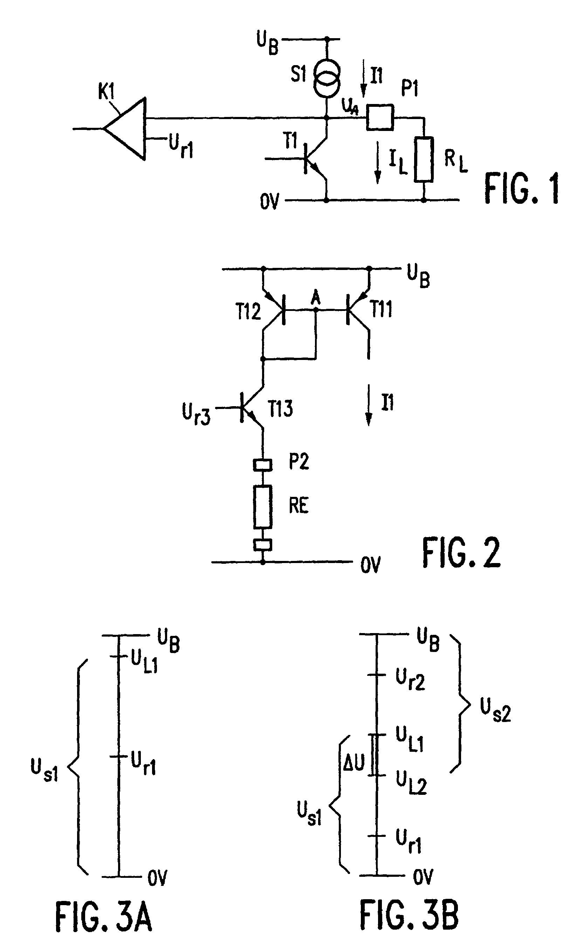

In Fig. 1 ist ein Schaltungspunkt P1, der eine Verbindung einer integrierten Schaltung nach außerhalb darstellt, innerhalb der integrierten Schaltung über einen Transistor T1 mit dem einen Pol 0V einer Betriebsspannung verbunden. Die Ansteuerung des Transistors T1 sowie weitere Elemente der integrierten Schaltung sind der Übersichtlichkeit halber weggelassen. Wenn der Transistor T1 gesperrt ist, ist der Schaltungspunkt P1 frei schwebend zwischen dem Pol $U_B$ und dem Pol 0V der Betriebsspannung, sofern nicht ein Leckwiderstand $R_L$ vorhanden ist, der einen vorgegebenen Toleranzwert unterschreitet. In Fig. 1 ist der Leckwiderstand als außerhalb der integrierten Schaltung liegend dargestellt, er kann jedoch ebenso auch oder zusätzlich in der integrierten Schaltung vorhanden sein.

Um einen Leckstrom $I_L$ durch einen solchen möglicherweise vorhandenen Leckwiderstand feststellen zu können, ist eine Stromquelle S1 vorgesehen, die zwischen $U_B$ und dem Schaltungspunkt P1 angeordnet ist und einen Prüfstrom I1 liefert. Praktisch ausgeführte Stromquellen weisen stets eine Sättigungsspannung auf, unterhalb der die Stromquelle keinen Strom mehr liefert. Wenn bei der Schaltung in Fig. 1 also kein bzw. nur ein geringer Leckstrom $I_L$ fließt, der kleiner ist als der Prüfstrom I1, wird die Spannung am Schaltungspunkt P1 so weit gegen $U_B$ gehen, bis über der Stromquelle S1 nur noch eine Restspannung liegt, unterhalb der die Stromquelle S1 keinen bzw. nicht mehr den vollen Prüfstrom liefert. Erst wenn der Leckwiderstand $R_L$ kleiner als ein vorgegebener Toleranzwert ist, kann der Prüfstrom I1 der Stromquelle S1 vollständig abfließen, und der Schaltungspunkt P1 nimmt eine niedrigere Spannung an.

An den Schaltungspunkt P1 ist nun ein Eingang eines Komparators K1 angeschlossen, dessen anderer Eingang eine Referenzspannung $U_{r1}$ erhält, die beispielsweise mit Hilfe eines nicht dargestellten Spannungsteilers zwischen $U_B$ und 0V erzeugt wird und etwa gleich der halben Betriebsspannung ist. Solange der Leckwiderstand $R_L$ genügend groß und damit der Leckstrom $I_L$ genügend klein ist, liegt die Spannung am Schaltungspunkt P1 über der Referenzspannung $U_{r1}$, und der Komparator K1 gibt ein niedriges Ausgangssignal ab. Sobald der Leckwiderstand den Toleranzwert unterschreitet und damit der Leckstrom $I_L$ den Wert des Prüfstroms I1 überschreitet, sinkt die Spannung am Schaltungspunkt P1 unter die Referenzspannung $U_{r1}$ und der Komparator K1 erzeugt ein hohes Ausgangssignal, das anzeigt, daß der Leckwiderstand zu klein ist.

Eine praktische Ausführung der Stromquelle S1 ist in Fig. 2 dargestellt. Darin wird die Stromquelle durch den pnp-Transistor T11 gebildet, dessen Emitter mit $U_B$ verbunden ist und dessen Basis mit einem Schaltungsknoten A verbunden ist. Dieser wird von einem pnp-Transistor T12 angesteuert, dessen Basis mit seinem Kollektor verbunden ist, so daß die Transistoren T11 und T12 einen Stromspiegel darstellen. Dadurch wird ein Referenzstrom, der aus dem Kollektor des Transistors T12 abgeleitet wird, auf den Kollektor des Transistors T11 gespiegelt und erzeugt dort einen Strom I1, der bei gleicher Geometrie der Transistoren T11 und T12 gleich dem Referenzstrom ist.

Der Referenzstrom wird von einem npn-Transistor T13 erzeugt, dessen Basis eine Referenzspannung $U_{r3}$ erhält und dessen Emitter mit einem weiteren Schaltungspunkt P2 verbunden ist, der über einen externen Widerstand $R_E$ mit 0V verbunden ist. Bei vorgegebener Referenzspannung $U_{r3}$ wird durch den Wert des externen Widerstandes $R_E$ der Referenzstrom bestimmt und damit auch der Toleranzwert des Leckwiderstands $R_L$, bei dessen Unterschreitung der Komparator K1 anspricht.

Der Kollektorstrom I1 des Transistors T11 kann nur fließen, solange der Transistor T11 nicht gesättigt ist, d.h. solange seine Spannung zwischen Emitter und Kollektor einen Mindestwert überschreitet. Dies ist in dem Diagramm in Fig. 3a deutlicher dargestellt. Die Spannung $U_{L1}$, die etwas unterhalb $U_B$ liegt, stellt die Sättigungsspannung des Transistors T11 dar. Der Kollektorstrom bzw. der Prüfstrom I1 kann also nur in dem Spannungsbereich $U_{S1}$ zwischen dem Grenzwert $U_{L1}$ der Kollektorspannung und 0V fließen. Die Referenzspannung $U_{r1}$ des Komparators liegt innerhalb des Spannungsbereichs $U_{s1}$. Daraus ist deutlich zu erkennen, daß bei einem genügend kleinen Leckstrom die Spannung am Schaltungspunkt P1 oberhalb von $U_{r1}$ liegt, nämlich bei $U_{L1}$, und wenn der Leckstrom den Prüfstrom überschreitet, sinkt die Spannung am Schaltungspunkt P1 und unterschreitet damit die Referenzspannung $U_{r1}$.

Die bisherige Beschreibung bezieht sich auf die Erkennung eines Leckwiderstands gegen nur einen Pol der Betriebsspannung, nämlich gegen 0V. Um einen Leckwiderstand gegen jeden der beiden Pole zu erkennen, müssen nicht nur Prüfströme in beiden Richtungen erzeugt werden, sondern auch die einzelnen Spannungswerte müssen zweckmäßig gewählt werden. Eine Möglichkeit hierfür ist in Fig. 3b dargestellt. Darin liegt der Grenzwert $U_{L1}$ etwa in der Mitte zwischen den beiden Spannungen $U_B$ und 0V. Der Prüfstrom I1 kann also fließen, solange der Schaltungspunkt P1 einen Wert in dem Spannungsbereich $U_{S1}$ hat. Für einen zweiten Prüfstrom mit entgegengesetzter Richtung gelten spiegelbildliche Verhältnisse, nämlich dieser Prüfstrom kann nur fließen, wenn der Schaltungspunkt einen Wert zwischen einem zweiten Grenzwert $U_{L2}$ und $U_B$ hat, nämlich im Spannungsbereich $U_{S2}$. Die beiden Grenzwerte $U_{L1}$ und $U_{L2}$ sind so gewählt, daß sich ein Spannungsbereich $\Delta U$ ergibt, in dem beide Prüfströme gleichzeitig fließen können.

Diese beiden Prüfströme können zwar im wesentlichen in gleicher Stärke erzeugt werden, jedoch ist eine exakte Übereinstimmung praktisch nicht erreichbar. Wenn nun angenommen wird, daß der Prüfstrom I1 größer ist als ein Prüfstrom I2 und der Leckwiderstand zunächst unendlich ist, wird sich am Schaltungspunkt P1 eine Spannung gleich $U_{L1}$ gemäß der früheren Beschreibung einstellen. Entsprechend wird, wenn der Prüfstrom I1 kleiner ist als ein Prüfstrom I2 in entgegengesetzter Richtung, am Schaltungspunkt P1 eine Spannung $U_{L2}$ entstehen. In jedem Fall liegt also die Spannung am Schaltungspunkt P1, solange der Leckstrom praktisch gleich Null ist, im Spannungsbereich $\Delta U$.

Auch der Komparator muß nun symmetrisch ausgeführt sein, und er vergleicht die Spannung am Schaltungspunkt P1 mit zwei Referenzspannungen $U_{r1}$ und $U_{r2}$, die beide außerhalb des Spannungsbereichs $\Delta U$ liegen. Wenn nun wieder angenommen wird, daß der Prüfstrom I1 größer ist als ein Prüfstrom I2 in entgegengesetzter Richtung, und es fließt nun ein Leckstrom infolge ines Leckwiderstands gegen 0V, addiert dieser sich im Schaltungspunkt P1 zu dem zweiten Prüfstrom, wie beim Vergleich mit Fig. 1 leicht zu erkennen ist, und wenn diese Summe der Ströme den Prüfstrom I1 überschreitet, geht die Spannung am Schaltungspunkt P1 auf den Grenzwert $U_{L2}$, jedoch nicht weiter, da dann der zweite Prüfstrom aufhört zu fließen. Erst wenn der Leckwiderstand so niedrig ist, daß der Leckstrom größer ist als der erste Prüfstrom, sinkt die Spannung am Schaltungspunkt P1 unter die in Fig. 3b angegebene Referenzspannung $U_{r1}$. Entsprechendes gilt auch für die andere Stromrichtung, d.h. nur bei einem Leckstrom infolge eines Leckwiderstands nach $U_B$, der größer ist als der zweite Prüfstrom, steigt die Spannung am Schaltungspunkt P1 bis über die zweite Referenzspannung $U_{R2}$. Die beiden Referenzspannungen für den Komparator müssen also außerhalb des Spannungsbereichs $\Delta U$ liegen, nämlich zwischen diesem Spannungsbereich und 0V bzw. $U_B$. Die Begrenzung der Prüfströme bei den Grenzwerten $U_{L1}$ und $U_{L2}$ kann beispielsweise dadurch erfolgen, daß die betreffenden Stromquellen bei diesen Spannungen geklemmt werden.

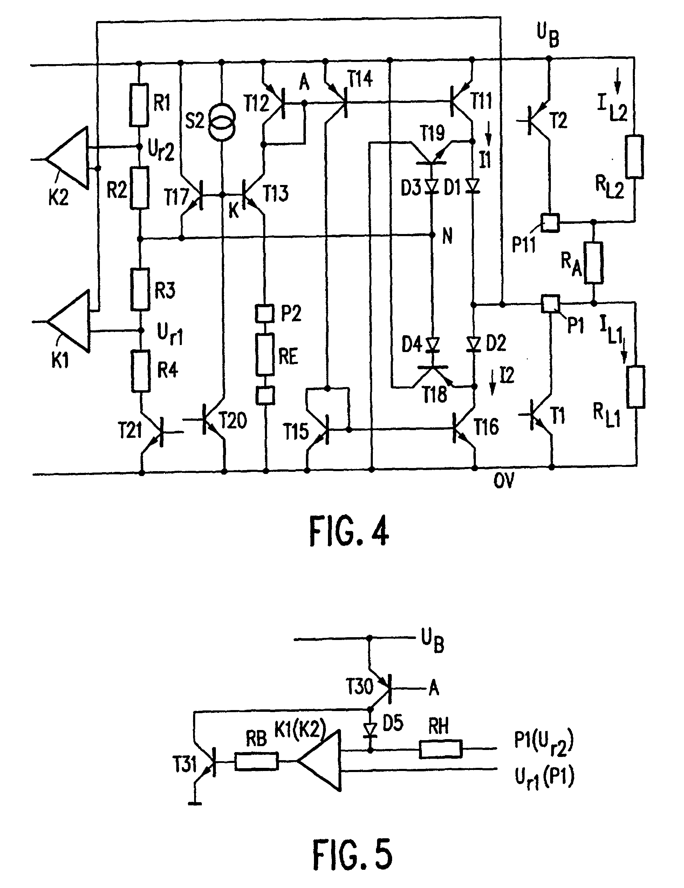

Eine vollständige Schaltung mit derartigen Stromquellen für zwei Prüfströme in zueinander entgegengesetzten Richtungen ist in Fig. 4 dargestellt, wobei der Fig. 2 entsprechende Elemente mit denselben Bezugszeichen bezeichnet sind. Der erste Prüfstrom I1 wird wieder durch einen pnp-Transistor T11 erzeugt, der über den Schaltungsknoten A mit dem pnp-Transistor T12 einen Stromspiegel bildet. Ferner ist ein pnp-Transistor T14 vorgesehen, der einen Kollektorstrom erzeugt, der bei gleicher Geometrie der Transistoren T11 und T14 den gleichen Wert hat wie der erste Prüfstrom I1.

Der Kollektorstrom des Transistors T14 wird als Steuerstrom einem weiteren Stromspiegel zugeführt, der die npn-Transistoren T15 und T16 umfaßt, und wenn diese beiden Transistoren wieder dieselbe Geometrie aufweisen, ist der vom Transistor T16 erzeugte zweite Prüfstrom I2 dem Betrag nach nahezu gleich dem ersten Steuerstrom I1, lediglich die Richtung bezüglich des Schaltungspunktes P1 ist entgegengesetzt.

Der Kollektor des Transistors T11, der den ersten Prüfstrom I1 liefert, ist mit dem Emitter eines pnp-Transistors T19 verbunden, dessen Kollektor mit 0V verbunden ist und dessen Basis über eine Diode D3 auf einen Schaltungsknoten N führt. Dieser Schaltungsknoten N ist mit einem Spannungsteiler aus den Widerständen R1 bis R4 mit $U_B$ bzw. über einen Transistor T21 mit 0V verbunden. Die Widerstände R1 und R4 haben gleiche Werte, und auch die Widerstände R2 und R3 haben untereinander gleiche Werte, so daß der Schaltungsknoten N auf der Spannung $0,5U_B$ liegt, wobei der Transistor T21 als durchgeschaltet angenommen wird. Der Kollektor des Transistors T11 kann also nicht positiver werden als $0,5U_B+2U_D$, wenn mit $U_D$ die Durchlaßspannung der Diode D3 bzw. die Emitter-Basis-Spannung des Transistors T19 bezeichnet wird. Durch die Wirkung der Diode D1, die zwischen dem Kollektor des Transistors T11 und dem Schaltungspunkt P1 liegt, ist dann der obere Grenzwert $U_{L1}=0,5U_B+U_D$. Die Diode D1 soll verhindern, daß ein Strom insbesondere vom Schaltungspunkt P1 in den Emitter des Transistors T19 fließt, wenn die Spannung an diesem Schaltungspunkt P1 aufgrund insbesondere eines Leckstroms positiv wird.

Entsprechendes gilt für den Prüfstrom I2, der vom Transistors T16 erzeugt wird. Dessen Kollektor ist mit dem Emitter eines npn-Transistors T18 verbunden, dessen Kollektor mit $U_B$ verbunden ist und dessen Basis über eine Diode D4 auf den Schaltungsknoten N führt. In entsprechender Weise ist zwischen den Kollektor des Transistors T16 und dem Schaltungspunkt P1 eine Diode D2 geschaltet, wodurch der Schaltungspunkt P1 durch den Prüfstrom I2 höchstens den Grenzwert $U_{L2}=0,5U_B-U_D$ annehmen kann. Abhängig davon, welcher der beiden Prüfströme I1 und I2 größer ist und in welche Richtung möglicherweise ein kleiner Leckstrom bezüglich des Schaltungspunktes P1 fließt, befindet sich dieser Schaltungspunkt entweder auf dem oberen Grenzwert $U_{L1}$ oder auf dem unteren Grenzwert $U_{L2}$, wie in Fig. 3b angedeutet ist.

Der Schaltungspunkt P1 ist bei der Schaltung nach Fig. 4 zum einen über den als gesperrt angenommenen Transistor mit 0V und zum anderen mit einem Lastwiderstand $R_A$ verbunden, dessen anderes Ende mit einem Schaltungspunkt P11 verbunden ist, der wiederum über einen pnp-Transistor T2 mit $U_B$ verbunden ist. Dieser letztere Transistor ist im normalen Betriebszustand ebenfalls gesperrt. Da der Lastwiderstand $R_A$ sehr niederohmig ist, wird über den Schaltungspunkt P1 auch ein Leckstrom $I_{L2}$, der beispielsweise durch einen Leckwiderstand $R_{L2}$ von $U_B$ zum Schaltungspunkt P11 fließt, überwacht.

Diese Überwachung erfolgt durch einen Fensterkomparator, der hier durch zwei einzelne Komparatoren K1 und K2 gebildet ist. Ein erster Eingang beider Komparatoren K1 und K2 ist mit dem Schaltungspunkt P1 verbunden, und ein zweiter Eingang des Komparators K1 erhält die Referenzspannung $U_{r1}$, die an dem Verbindungspunkt der Widerstände R3 und R4 des Spannungsteilers gebildet wird, und ein zweiter Eingang des Komparators K2 erhält die Referenzspannung $V_{r2}$, die am Verbindungspunkt der Widerstände R1 und R2 des Spannungsteilers gebildet wird. Bei entsprechender Dimensionierung der Widerstände R1 bis R4 liegen die beiden Referenzspannungen $U_{r1}$ und $U_{r2}$ genügend weit außerhalb des Spannungsbereichs $\Delta U$, wie in Fig. 3b gezeigt ist. Wenn also der Leckwiderstand $R_{L_1}$ zu klein ist und einen Leckstrom $I_{L_1}$ führt, der den Prüfstrom I1 übersteigt, wird die Spannung am Schaltungspunkt P1 negativer als die Referenzspannung $U_{r1}$, so daß der Komparator K1 ein Ausgangssignal abgibt. Der zugehörige Wert des Leckwiderstands $R_{L_1}$ ist dabei von der Betriebsspannung unabhängig, wie die nachfolgende Ableitung zeigt.

Die Spannung am Schaltungsknoten N wird mit $U_N$ bezeichnet und beträgt

$$U_N = U_B \frac{R3+R4}{R1+R2+R3+R4}$$

Dann ist der Strom $I_E$ durch den Widerstand RE

$$I_E = \frac{U_N}{RE} = \frac{U_B}{RE} \frac{R3+R4}{R1+R2+R3+R4}$$

Für die Referenzspannung $U_{r1}$ gilt

$$U_{r1} = U_B \frac{R4}{R1+R2+R3+R4}$$

Es wird vorausgesetzt, daß der Prüfstrom I1 über die Stromspiegel gleich groß ist wie der Referenzstrom $I_E$. Der Komparator K1 gibt ein Ausgangssignal ab, wenn die Spannung an beiden Eingängen gleich ist, d.h. wenn die Spannung am Schaltungspunkt P1 gleich der Referenzspannung $U_{r1}$ ist, also

$$I_E R_{L1} < U_{r1}$$

$$\frac{U_B}{RE} \frac{R3+R4}{R1+R2+R3+R4} R_{L1} < U_B \frac{R4}{R1+R2+R3+R4}$$

Daraus folgt

$$R_{L1} < RE \frac{R4}{R3+R4}$$

Hieraus ist erkennbar, daß der Wert des Leckwiderstands $R_{L1}$, bei dessen Unterschreiten der Komparator K1 ein Ausgangssignal abgibt, nur von dem externen Widerstand RE und dem Spannungsteilerverhältnis abhängt, jedoch nicht von der Betriebsspannung.

Eine entsprechende Beziehung gilt für einen Leckwiderstand $R_{L2}$ gegen $U_B$. Der Komparator K2 gibt ein Ausgangssignal ab, wenn der Wert des Leckwiderstands $R_{L2}$ einen Wert

$$R_{L2} < RE \frac{R1}{R3+R4}$$

unterschreitet und die Spannung am Schaltungspunkt P1 über die Referenzspannung $U_{r2}$ ansteigt. Die beiden Ausgangssignale der Komparatoren können getrennt verarbeitet oder, falls gewünscht, auch zu einem gemeinsamen Ausgangssignal zusammengefaßt werden.

Die Prüfströme I1 und I2 werden durch einen Referenzstrom des Transistors T13 bestimmt, wie anhand der Fig. 2 erläutert wurde, und dieser Strom wird durch einen externen Widerstand $R_E$ bestimmt, der an den Schaltungspunkt P2 angeschlossen ist, sowie durch die Spannung an der Basis des Transistors T13, der mit einem Schaltungsknoten K verbunden ist. Dieser Schaltungsknoten K ist ferner mit der Basis eines npn-Transistors T17 verbunden, dessen Emitter mit dem Schaltungsknoten N verbunden ist.

Ferner wird dem Schaltungsknoten K ein Strom aus einer Stromquelle S2 zugeführt. Durch die Verbindung der Transistoren T17 und T13 wird erreicht, daß der Emitter des Transistors T13 und damit der Schaltungspunkt P2 praktisch die gleiche Spannung wie der Schaltungsknoten N führt, nämlich $0,5U_B$.

In Fig. 4 sind die Eingänge der Komparatoren vereinfacht direkt mit dem Schaltungspunkt P1 bzw. mit den Referenzspannungen $U_{r1}$ und $U_{r2}$ verbunden dargestellt. Damit die Komparatoren jedoch ein eindeutiges stabiles binäres Ausgangssignal abgeben, werden sie tatsächlich so aufgebaut, daß sie eine Hysterese aufweisen. Dies ist in Fig. 5 näher dargestellt. Dabei ist also der eine Eingang jedes der beiden Komparatoren K1 und K2 über einen Widerstand RH mit dem betreffenden Schaltungspunkt verbunden, und zwar beim Komparator K1 mit dem Schaltungspunkt P1 und beim Komparator K2 mit dem Schaltungspunkt $U_{r2}$. Der andere Eingang des Komparators K1 ist mit der Referenzspannung $U_{r1}$ und der andere Eingang des Komparators K2 mit dem Schaltungspunkt P1 verbunden. Die weitere Erläuterung bezieht sich unmittelbar nur auf den Komparator K1 und gilt für den Komparator K2 entsprechend.

Der mit dem Widerstand RH verbundene Eingang des Komparators K1 ist über eine Diode D5 mit einem Stromgenerator verbunden, der durch den Kollektor eines pnp-Transistors T30 gebildet wird, dessen Emitter mit $U_B$ und dessen Basis mit dem Schaltungspunkt A in Fig. 4 verbunden ist. Dadurch liefert der Transistor T30 als Stromgenerator einen Strom, der von dem Referenzstrom $I_E$ abhängt und ein fester Bruchteil davon ist, indem die Emitterfläche des Transistors T30 entsprechend kleiner als die Emitterfläche des Transistors T12 gewählt wird.

Wenn der Komparator K1 ein Ausgangssignal abgeben soll, gilt nun die Beziehung

$$I_E R_L < U_{r1} + U_H$$

Darin ist die Spannung $U_H$ die am Widerstand RH abfallende Spannung

$$U_H = I_E \times RH$$

wobei x der Faktor ist, um den die Emitterfläche des Transistors T30 kleiner ist als die Emitterfläche des Transistors T12, wodurch der Strom auch entsprechend kleiner ist. Damit ergibt sich nun

$$R_L < \frac{U_{r1}}{R3+R4} + x \, RH$$

$$R_L < RE \frac{R4}{R3+R4} + x \, RH$$

Es ist zu erkennen, daß weiterhin der Wert des Leckwiderstandes, bei dem der Komparator ein Ausgangssignal abgibt, unabhängig von der Betriebsspannung ist.

Sobald nun die Schaltbedingung für den Komparator erreicht ist und das Ausgangssignal erzeugt wird, schaltet dieses über einen Widerstand RB einen Transistor T31 ein, der den Strom des Stromgenerators T30 ableitet, so daß nun am Widerstand RH keine Spannung mehr abfällt. Dadurch bleibt der Komparator K1 stabil in seiner umgeschalteten Lage, auch bei kleinen Spannungsschwankungen am Schaltungspunkt P1.

Für den Komparator K2 ist eine entsprechende Schaltung vorhanden, die in gleicher Weise arbeitet und deswegen hier nicht näher erläutert zu werden braucht.

Die Prüfung auf Leckströme muß allgemein nicht ständig durchgeführt werden, sondern es genügt eine Prüfung, die periodisch oder zu vorgegebenen Zeitpunkten durchgeführt wird. Dafür ist die Schaltung nach Fig. 4 so ausgestaltet, daß die Stromquellen für die Prüfströme auch abgeschaltet werden können. Dies geschieht über die Transistoren T20 und T21. Solange der Transistor T21 leitend und der Transistor T20 gesperrt ist, erfolgt die Erzeugung der Prüfströme in beschriebener Weise. Wenn jedoch der Transistor T21 gesperrt und der Transistor T20 leitend ist, ist damit auch der Transistor T13 gesperrt, und es fließt kein Referenzstrom, und damit sind auch alle Transistoren T11 bis T19 stromlos.

**Patentansprüche**

1. Schaltungsanordnung zum Überwachen eines Schaltungspunktes, der in einem vorgegebenen Betriebszustand im störungsfreien Fall im wesentlichen zwischen einem ersten und einem zweiten Pol (OV, $U_B$) einer Betriebsspannung frei schwebend ist, auf einen Störzustand in Form eines Leckwiderstandes gegen wenigstens den einen Pol der Betriebsspannung, mit einer eine Stromquelle (S1) aufweisenden Prüfanordnung, die mit dem Schaltungspunkt gekoppelt ist, um diesem wenigstens einen vorgegebenen Prüfstrom zuzuführen, und mit einer Auswerteanordnung, die wenigstens einen Komparator aufweist, von dem ein Eingang mit dem Schaltungspunkt gekoppelt ist, um ein erstes Ausgangssignal abzugeben, wenn ein Strom durch den Leckwiderstand fließt,
   **dadurch gekennzeichnet, daß** die Stromquelle eine erste Stromquelle (T11) enthält, um dem Schaltungspunkt einen ersten Prüfstrom (I1) mit einer ersten Richtung zum ersten Pol (0V) zuzuführen, dessen Wert einem vorgegebenen Toleranzwert des Leckwiderstands entspricht, wobei dieser erste Prüfstrom nur fließt, wenn die Spannung zwischen dem Schaltungspunkt (P1) und dem ersten Pol (0V) einen vorgegebenen ersten Grenzwert ($U_{L1}$) unterschreitet, und daß der Komparator (K1) mit dem Schaltungspunkt (P1) verbunden ist, um die Spannung ($U_A$) an diesem Schaltungspunkt mit einer vorgegebenen ersten Referenzspannung ($U_{r1}$), die kleiner ist als der erste Grenzwert ($U_{L1}$), zu vergleichen und das erste Ausgangssignal abzugeben, wenn die Spannung zwischen dem Schaltungspunkt (P1) und dem einen Pol (0V) der Betriebsspannung die erste Referenzspannung ($U_{r1}$) unterschreitet.

2. Schaltungsanordnung nach Anspruch 1 zum Überwachen des Schaltungspunktes auf einen Leckwiderstand gegen jeden der beiden Pole der Betriebsspannung,
   **dadurch gekennzeichnet, daß** die Stromquelle eine zweite Stromquelle (T16) enthält, um dem Schaltungspunkt einen zweiten Prüfstrom (I2) mit einer zur ersten Richtung entgegengesetzten zweiten Richtung zum zweiten Pol ($U_B$) zuzuführen, dessen Wert ebenfalls dem vorgegebenen Toleranzwert entspricht, wobei der zweite Prüfstrom (I2) nur fließt, wenn die Spannung zwischen dem Schaltungspunkt (P1) und dem anderen Pol ($U_B$) einen vorgegebenen zweiten Grenzwert ($U_{L2}$) unterschreitet, wobei die beiden Grenzwerte einen Spannungsbereich ($\Delta U$) einschließen, in dem beide Prüfströme (I1, I2) fließen, und daß der Komparator ein Fensterkomparator (K1, K2) ist, um die Spannung ($U_A$) am Schaltungspunkt (P1) mit einer ersten und einer zweiten Referenzspannung ($U_{r1}$, $U_{r2}$) zu vergleichen, die außerhalb des Spannungsbereichs ($\Delta U$) liegen, und um wenigstens ein Signal abzugeben, wenn die Spannung ($U_A$) am Schaltungspunkt (P1) außerhalb des durch die Referenzspannungen ($U_{r1}$, $U_{r2}$) begrenzten Spannungsbereichs liegt.

3. Schaltungsanordnung nach Anspruch 2,
   **dadurch gekennzeichnet, daß** die erste und zweite Stromquelle (T11, T16) über wenigstens einen ersten Stromspiegel (T15, T16) miteinander gekoppelt sind, der zur Erzeugung des zweiten Prüfstroms (I2) einen Steuerstrom von einem zweiten Stromspiegel (T12, T14, T11) empfängt, der aus einem Referenzstrom den Steuerstrom und den ersten Prüfstrom (I1) erzeugt.

4. Schaltungsanordnung nach Anspruch 3, **dadurch gekennzeichnet, daß** der Referenzstrom durch einen zwischen einem Anschluß (P2) der Prüfschaltung, der im wesentlichen auf einem vorgegebenen Bruchteil der Betriebsspannung liegt, und dem einen Pol (0V) angeschlossenen externen Widerstand (RE) einstellbar ist.

5. Schaltungsanordnung nach einem der Ansprüche 1 bis 4, **dadurch gekennzeichnet, daß** jede der beiden Referenzspannungen ($U_{r1}$, $U_{r2}$) durch einen zwischen den Polen ($U_B$, 0V) der Betriebsspannung angeordneten Spannungsteiler (R1 bis R4) bestimmt ist.

6. Schaltungsanordnung nach einem der Ansprüche 2 bis 5, **dadurch gekennzeichnet, daß** der Fensterkomparator zwei einzelne Komparatoren (K1, K2) enthält, von denen jeder die Spannung ($U_A$) am Schaltungspunkt (P1) mit einer anderen der beiden Referenzspannungen ($U_{r1}$, $U_{r2}$) vergleicht.

7. Schaltungsanordnung nach Anspruch 6, wobei jeder Komparator zwei Eingänge und einen Ausgang aufweist, **dadurch gekennzeichnet, daß** der eine Eingang jedes Komparators (K1, K2) mit einem Stromgenerator (T30) und mit einem Widerstand (RH) gekoppelt ist, dessen anderes Ende mit dem Schaltungspunkt (P1) bzw. mit der entsprechenden Referenzspannung (Ur2) verbunden ist, wobei der vom Stromgenerator (T30) gelieferte Strom vom Referenzstrom abhängig und über einen vom Signal am Ausgang des Komparators ansteuerbaren Transistor (T31) nach Masse ableitbar ist.

8. Schaltungsanordnung nach einem der Ansprüche 2 bis 7, **dadurch gekennzeichnet, daß** der Spannungsbereich ($\Delta U$) im wesentlichen in der Mitte zwischen den Potentialen der Pole (0V, $U_B$) der Betriebsspannung liegt.

9. Schaltungsanordnung nach einem der vorhergehenden Ansprüche, **dadurch gekennzeichnet, daß** Mittel (T20, T21) zum Abschalten der Stromquellen (T11, T16) vorgesehen sind.

**Claims**

1. Circuit arrangement for monitoring a circuit point, which in a defined operating state in the fault-free case is substantially floating between a first and a second terminal (0V, $U_B$) of an operating voltage, for a fault condition in the form of a leakage resistance to at least the one terminal of the operating voltage, comprising a test arrangement which contains a current source (S1) and which is connected to the circuit point in order to supply this with at least one defined test current, and comprising an evaluation arrangement containing at least one comparator, one input of which is connected to the circuit point in order to output a first output signal if a current flows through the leakage resistance, **characterised in that** the current source contains a first current source (T11) for supplying the circuit point with a first test current (I1) in a first direction to the first terminal (0V), whose value equals a defined tolerance value of the leakage resistance, this first test current only flowing if the voltage between the circuit point (P1) and the first terminal (0V) falls below a defined first limit ($U_{L1}$), and **in that** the comparator (K1) is connected to the circuit point (P1) in order to compare the voltage ($U_A$) at this circuit point with a defined first reference voltage ($U_{r1}$), which is smaller than the first limit ($U_{L1}$), and to output the first output signal if the voltage between the circuit point (P1) and the one terminal (0V) of the operating voltage falls below the first reference voltage ($U_{r1}$).

2. Circuit arrangement according to claim 1 for monitoring the circuit point for a leakage resistance to each of the two terminals of the operating voltage, **characterised in that** the current source contains a second current source (T16) for supplying the circuit point with a second test current (I2) in a second direction to the second terminal ($U_B$) that is opposite to the first direction, whose value also equals the defined tolerance value, the second test current (I2) only flowing if the voltage between the circuit point (P1) and the other terminal ($U_B$) falls below a defined second limit ($U_{L2}$), where the two limits enclose a voltage range ($\Delta U$) in which both test currents (I1, I2) flow, and **in that** the comparator is a window comparator (K1, K2) for comparing the voltage ($U_A$) at the circuit point (P1) with a first and a second reference voltage ($U_{r1}$, $U_{r2}$), which lie outside the voltage range ($\Delta U$), and to output at least one signal if the voltage ($U_A$) at the circuit point (P1) lies outside the voltage range bounded by the reference voltages ($U_{r1}$, $U_{r2}$).

3. Circuit arrangement according to claim 2, **characterised in that** the first and second current source (T11, T16) are connected together via at least one first current mirror (T15, T16), which, in order to generate the second test current (I2), receives a drive current from a second current mirror (T12, T14, T11), which generates the drive current and the first test current (I1) from a reference current.

4. Circuit arrangement according to claim 3, **characterised in that** the reference current is adjustable by means of an external resistor (RE) connected between one connection (P2) of the test circuit, which basically lies at a defined fraction of the operating voltage, and the one terminal (0V).

5. Circuit arrangement according to one of the claims 1 to 4, **characterised in that** each of the two reference voltages ($U_{r1}$, $U_{r2}$) is set by a potential divider (R1 to R4) arranged between the terminals ($U_B$, 0V) of the operating voltage

6. Circuit arrangement according to one of the claims 2 to 5, **characterised in that** the window comparator contains two separate comparators (K1, K2), each of which compare the voltage ($U_A$) at the circuit point (P1) with one other of the two reference voltages ($U_{r1}$, $U_{r2}$).

7. Circuit arrangement according to claim 6, where each comparator has two inputs and one output, **characterised in that** the one input of each comparator (K1, K2) is connected to a current generator (T30) and to a resistor (RH), whose other end is connected to the circuit point (P1), or to the appropriate reference voltage ($U_{r2}$) respectively, the current supplied by the current generator (T30) being dependent on the reference current, and able to be diverted to ground via a transistor (T31) drivable by the signal at the output of the comparator.

8. Circuit arrangement according to one of the claims 2 to 7, **characterised in that** the voltage range ($\Delta U$) lies substantially in the centre of the potentials of the operating voltage terminals (0V, $U_B$).

9. Circuit arrangement according to one of the preceding claims, **characterised in that** means (T20, T21) for switching off the current sources (T11, T16) are provided.

**Revendications**

1. Agencement de circuit pour le contrôle d'un point de commutation qui, dans un état prédéterminé de fonctionnement, est librement flottant, dans le cas sans anomalies, pour l'essentiel entre un premier et un deuxième pôle (0V, $U_B$) d'une tension de service, pour détecter un état d'anomalie sous forme d'une résistance de fuite contre au moins un pôle de la tension de service, avec un dispositif de vérification présentant une source de courant (51), lequel est couplé avec le point de commutation pour amener à celui-ci au moins un courant de vérification prédéterminé, et avec un dispositif d'évaluation qui présente au moins un comparateur dont une entrée est couplée avec le point de commutation pour émettre un premier signal de sortie lorsqu'un courant circule à travers la résistance de fuite,

 **caractérisé en ce que** la source de courant contient une première source de courant (T11) pour amener au point de commutation un premier courant de vérification (I1) avec une première direction vers le premier pôle (0V), dont la valeur correspond à une valeur de tolérance prédéterminée de la résistance de fuite, ce premier courant de vérification circulant seulement lorsque la tension entre le point de commutation (P1) et le premier pôle (0V) n'atteint pas une première valeur limite prédéterminée ($U_{L1}$), et **en ce que** le comparateur (K1) est relié avec le point de commutation (P1) pour comparer la tension ($U_A$) sur ce point de commutation avec une première tension de référence prédéterminée ($U_{r1}$), qui est inférieure à la première valeur limite ($U_{L1}$), et émettre le premier signal de sortie lorsque la tension entre le point de commutation (P1) et un pôle (0V) de la tension de service n'atteint pas la première tension de référence ($U_{r1}$).

2. Agencement de circuit selon la revendication 1 pour le contrôle du point de commutation pour détecteur une résistance de fuite contre chacun des deux pôles de la tension de service, **caractérisé en ce que** la source de courant présente une deuxième source de courant (T16) pour amener au point de commutation un deuxième courant de vérification (I2) avec une deuxième direction, opposée à la première direction, vers le deuxième pôle ($U_B$), dont la valeur correspond également à la valeur de tolérance prédéterminée, le deuxième courant de vérification (I2) circulant seulement lorsque la tension entre le point de commutation (P1) et l'autre pôle ($U_B$) n'atteint pas une deuxième valeur limite prédéterminée ($U_{L2}$). les deux valeurs limites délimitant une plage de tension ($\Delta U$) dans laquelle les deux courants de vérification (I1, I2) circulent, et **en ce que** le comparateur est un comparateur à fenêtre (K1, K2) pour comparer la tension ($U_A$) au point de commutation (P1) avec une première et une deuxième tensions de référence ($U_{r1}$, $U_{r2}$), qui sont situées en dehors de la plage de tension ($\Delta U$), et pour émettre au moins un signal lorsque la tension ($U_{A)}$ au point de commutation (P1) se situe en dehors de la plage de tension délimitée par les tensions de référence ($U_{r1}$, $U_{r2}$).

**3.** Agencement de circuit selon la revendication 2.

**caractérisé en ce que** la première et la deuxième sources de courant (T11, T16) sont couplées l'une à l'autre par au moins un premier système symétrique de courant (T15, T16), qui, pour la production du deuxième courant de vérification (I2) reçoit un courant de commande d'un deuxième système symétrique de courant (T12, T14, T11) qui, à partir d'un courant de référence, produit le courant de commande et le premier courant de vérification (I1).

**4.** Agencement de circuit selon la revendication 3,

**caractérisé en ce que** le courant de référence est réglable par une résistance externe (RE) connectée entre un raccordement (P2) du circuit de vérification, qui se situe pour l'essentiel à une fraction prédéterminée de la tension de service, et un pôle (0V).

**5.** Agencement de circuit selon l'une des revendications 1 à 4,

**caractérisé en ce que** chacune des deux tensions de référence ($U_{r1}$, $U_{r2}$) est déterminée par un diviseur de tension (R1 à R4) disposé entre les pôles ($U_B$, 0V) de la tension de service.

**6.** Agencement de circuit selon l'une des revendications 2 à 5,

**caractérisé en ce que** le comparateur à fenêtre contient deux comparateurs individuels (K1, K2) dont chacun compare la tension ($U_A$) au point de commutation (P1) à une autre des deux tensions de référence ($U_{r1}$, $U_{r2}$).

**7.** Agencement de circuit selon la revendication 6, dans lequel chaque comparateur présente deux entrées et une sortie,

**caractérisé en ce qu'**une entrée de chaque comparateur (K1, K2) est couplée avec un générateur de courant (T30) et une résistance (RH) dont l'autre extrémité est reliée au point de commutation (P1) et à la tension de référence ($U_{r2}$) correspondante, le courant fourni par le générateur de courant (T30) étant fonction du courant de référence et est extrait, par l'intermédiaire d'un transistor (T31) commandé par le signal à la sortie du comparateur, selon la masse.

**8.** Agencement de circuit selon l'une des revendications 2 à 7,

**caractérisé en ce que** la plage de tension ($\Delta U$) se situe essentiellement au centre entre les potentiels des pôles (0V, $U_B$) de la tension de service.

**9.** Agencement de circuit selon l'une des revendications précédentes,

**caractérisé en ce que** des moyens (T20, T21) sont prévus pour déconnecter les sources de courant (T11, T16).

FIG. 1

FIG. 2

FIG. 3A

FIG. 3B

FIG. 4

FIG. 5